# EUROPEAN PATENT SPECIFICATION

(11) **EP 0 336 059 B1**
(45) Date of publication and mention of the grant of the patent: **20.10.1993**
(21) Application number: 89101387.2
(22) Date of filing: 27.01.1989
(51) Int. Cl.: B24B 7/06, H05K 3/26

(54) **A method of surface grinding of planar member**
Oberflächenschleifverfahren für ebene Bauteile
Procédé pour meuler la surface d'éléments plans

(30) Priority: 25.03.1988 JP 71167/88; 30.03.1988 JP 76900/88
(43) Date of publication of application: 11.10.1989
(73) Proprietor: Nippon CMK Corp., Iruma-Gun Saitama (JP)
(72) Inventor: Seki, Kameharu, Kawagoe-Shi Saitama (JP); Kubo, Isamu, Isesaki-Shi Gunma (JP)
(74) Representative: Schickedanz, Willi, Dipl.-Ing.

(56) References cited:
- DE-A- 2 331 646
- DE-A- 2 452 700
- DE-A- 2 800 217
- DE-C- 820 888
- GB-A- 2 053 043
- US-A- 1 331 984
- US-A- 2 548 979
- US-A- 3 636 662
- US-A- 3 734 700

## Description

The present invention relates to a grinding device for grinding a planar member, comprising grinding means and driving means for moving said grinding means

### Description of the Prior Art

An article abrading apparatus having an article carrier belt and arms including abrading members moving across the belt with abrasive reciprocating motion is already known (US-A-3 734 700). This apparatus which may be used for abrading circuit boards and the like comprises lifting means associated with said arms for orienting the elevation of each arm above an article on the belt to make abrading contact with the surfaces of said circuit boards under each arm.

### Technical Problem

The object of the present invention is to solve the above mentioned problem, and to provide an improved grinding method to perform two grinding functions continuously by one device which may have a brush and a grinding stone.

### Solution of the Technical Problem

According to the present invention, the above problem is solved by a grinding device according to claim 1 and, respectively, by a method according to claim 8.

A conventional rotary grinding head can never have two functions, and only the surface grinding device of the invention having a rectangular grinding member of substantially planar grinding surface supported through an eccentric shaft to perform plane eccentric motion can allow a constructional possibility.

### Advantageous Effects of the Invention

The grinding member having two different grinding means and driven by one eccentric shaft, according to the present invention, performs two grinding processes on one table so that surface finishing process of planar member is simplified.

### Brief Description of the Drawings

Figure 1 is a perspective view of a surface grinding apparatus for surface grinding printed wiring boards, according to one embodiment of the method of the present invention.

Figure 2 is a schematic front view of a portion of Fig. 1.

Figure 3 is a perspective view of a portion of Fig. 1 showing surface grinding of a printed wiring board.

Figure 4 is a plan view of a brush and a grinding stone, according to another embodiment of the present invention, and

Figure 5 is an end view of Fig. 4.

### Detailed Description of the Preferred Embodiments

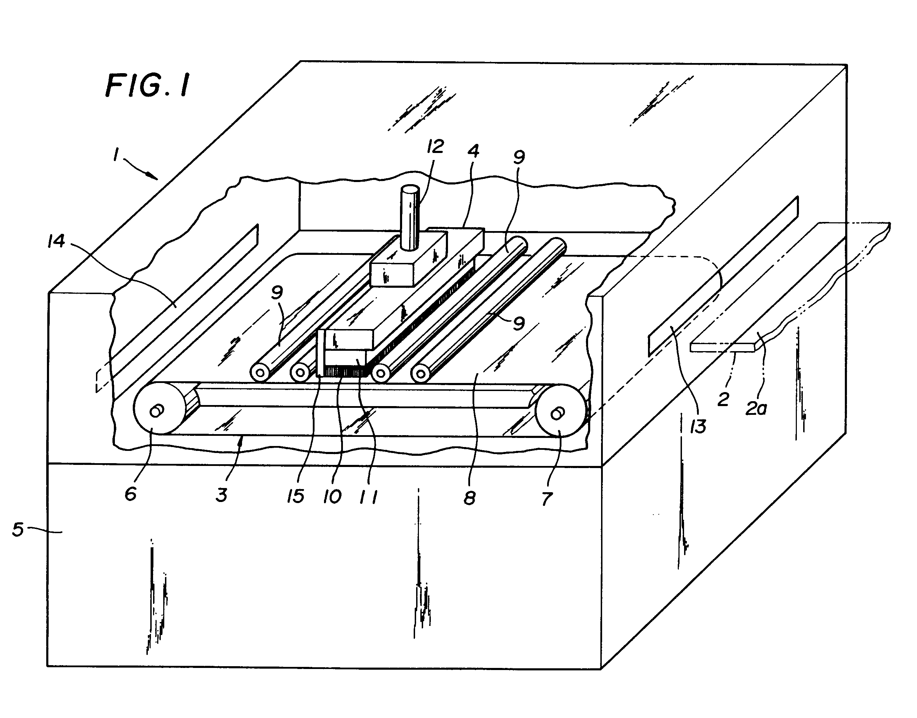

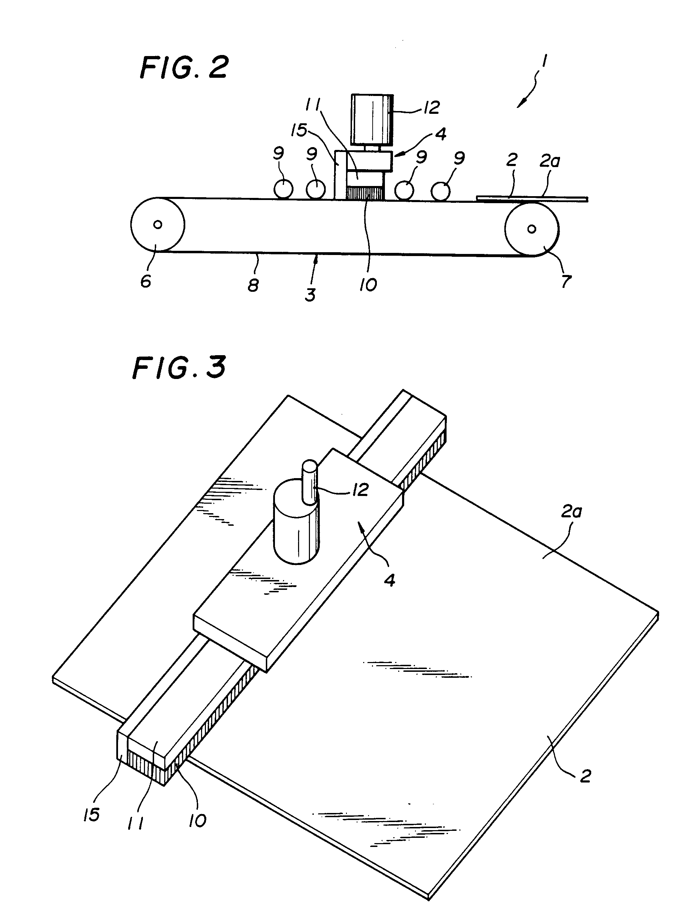

Fig. 1 illustrates a surface grinding apparatus 1 including a conveyor device 3 to convey printed wiring boards 2 as shown in Fig. 2. Also shown is a grinding device 4 for grinding a surface 2a of the printed wiring board 2 which is conveyed by the conveyor device 3 as well as an apparatus body 5 receiving the conveyor device 3 and the grinding device 4.

The conveyor device 3 includes rotatably supported two conveyor rolls 6 and 7, and an endless belt 8 around the rolls 6 and 7. Guide rolls 9 guide the printed wiring boards 2 on the belt 8. An eccentric shaft 12 drives a brush support 11 with a brush body 10 eccentrically on one plane so that every portion of the brush body 10 receives the same kinetic energy.

According to the present invention, the grinding device 4 includes the brush body 10, the brush support 11, a grinding stone 15 which is downstream from and parallel with the brush body 10, and the eccentric shaft 12 secured with the brush support 11. The brush body 10 is attached under the relatively long and rectangular planar brush support 11. The brush support 11 and the grinding stone 15 are driven eccentrically through the eccentric shaft 12. The brush support 11 and the grinding stone 15 are supported such that the urging forces to grind the surface 2a of the printed wiring board 2 can be regulatable. However, the brush support 11 and the grind stone 15 may be secured with each other as desired when only the urging force of the grinding stone 15 is to be regulated.

As the brush support 11 and the grinding stone 15 are driven by the eccentric shaft 12 on one plane, the upstream side brush body 10 forms grinding traces on the surface of the printed wiring board 2 uniformly and the downstream side grinding stone 15 forms smooth ground surface smoothing out of the ground traces of the brush 10.

On both sides of the apparatus body 5, inlet and outlet openings 13 and 14 are formed to supply and discharge the printed wiring boards.

Now, the method of grinding the surface 2a of the printed wiring board 2 by the surface grinding apparatus 1 will be described.

At first, printed wiring boards 2 to be surface finished are supplied through the opening 13. The supplied printed wiring boards 2 are fed sequentially through the conveyor device 3 to the grinding device 4.

The brush body 10 and the grinding stone 15 are driven eccentrically on a plane through the eccentric shaft 12 to grind the surface 2a of the printed wiring board 2. The eccentric motion of the brush body 10 and the grinding stone 15 forms generally spiral brush traces on the surface 2a by the upstream side brush 10, and then the brush traces are ground off by the downstream grinding stone 15.

Then, the surface finished printed wiring board 2 is conveyed by the conveyor belt 8 to the discharge outlet 14.

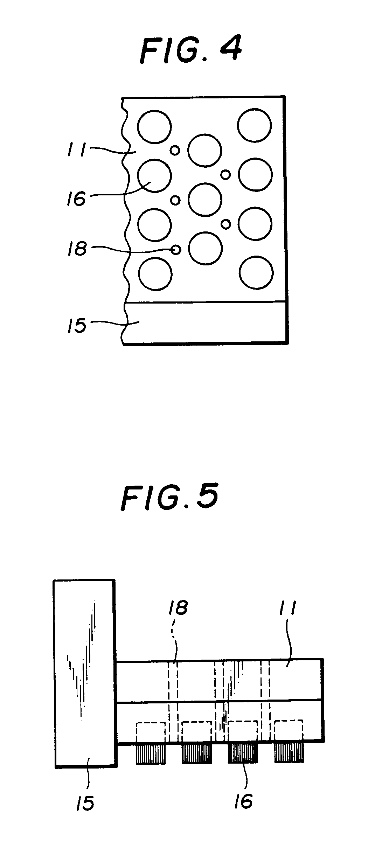

Figs. 4 and 5 show another embodiment which is preferable to surface grind relatively soft material, e. g. copper clad on the printed wiring board 2. Same reference numeral shows same or similar part or portion with the first embodiment.

The brush 10 includes many brush bundles 16 and the fibers forming the bundle 16 contain grinding material. The brush body 11 has many water feed openings 18 to inject water from water supply, not shown. The grinding stone 15 which is parallel with the brush body 11 is a rubber grinding stone in the embodiment shown. The arrangement can be used as parallel two different grinding means without necessitating a precise relative position regulating device to obtain the required surface finish.

As described in detail, according to the present invention, planar brush body 10 and the parallel grinding stone 15 are simultaneously and eccentrically driven by one eccentric shaft 12 on one plane so that uniform brush traces are formed upstream side by the brush 10 and the brush traces are smoothed out by the downstream side grinding stone 15. Thus, the surface 2a of the printed wiring board 2 can be surface finished by one process, and the finished surface is sufficient to perform later processes of good laminate adhering, good printing ink border and good fine pattern forming.

Further, as the brush is planar, in contrast to conventional circular brush, the brush can be manufactured easily to reduce manufacturing cost. Also, as the apparatus is essentially an apparatus to perform one grinding function so that simple and cheap construction and short working line can be realized.

Also, in the embodiment shown in Fig. 1, the grinding brush device 4 may include water injection means, not shown, to inject high pressure water into the brush body 10 to wash out copper powder and debris from the surface 2a of the printed wiring board to obtain clean finish.

As described, according to the present invention, two different kinds of plane finishing processes can be performed by only one work shaft simply and accurately. Thus, simple apparatus, easy working, low cost, and accurate finishing can be realized.

## Claims

1. Grinding device for grinding a planar member (2) comprising grinding means (15) and driving means (12) for moving said grinding mean (15), **characterized by**:
a) a brush support (11) having a substantially rectangular brush body (10) on its lower side;
b) a substantially rectangular grinding means (15) connected to the brush support (11), the lower end of said grinding means (15) being arranged substantially on the same level as the lower end of said brush body (10);
c) a shaft (12) being connected to said driving means (12) and to both said brush support (11) and said grinding means (15) and being arranged eccentrically with respect to the center axis of said brush support (11) and said grinding means (15).

2. Grinding device according to claim 1, **characterized in that** said brush support (11) and said grinding means (15) are slabs having rectangular cross-sections, the longer sides of said slabs being arranged parallel to each other.

3. Grinding device according to claim 1, **characterized by** a conveyor device (3) for supplying a planar member (2) to said brush body (10) and said grinding means (15).

4. Grinding device according to claim 3, **characterized by** a housing (1) having a first slot (13) for introducing said planar member (2) into said housing (1) and a second slot (14) for removing said planar member (2) from said housing, the conveyor device (3) being arranged between said first and said second slot (13, 14).

5. Grinding device according to claim 1, **characterized by** high pressure water means for injecting water into said brush body (10) to wish out copper powder and debris from the surface (2a) of the grinded planar member (2).

6. Grinding device according to claim 1, **characterized in that** the planar member is a printed wiring board (2) and that said printed wiring board is grinded on the conveyor device (3) by grinding means (15).

7. Grinding device according to claim 1, **characterized in that** the brush support (11) and a grinding stone (15) are supported such that the urging forces to grind the planar member (2) are regulatable.

8. Method for grinding a planar member (2) with a grinding means (15) and with driving means (12) for moving said grinding means (15), **characterized by** the steps:
a) moving a planar member (2) to be grinded from a first position (13) to a second position (14);
b) grinding and cleaning said planar member (2) between said first position (13) and said second position (14) by eccentrically moving said grinding means (15) together with a brush means (10) by a shaft (12) being arranged eccentrically with respect to the center of said grinding means (15) over the surface of said planar member (2), whereby said grinding means (15) is arranged between said second position (14) and said brush means (10), whereby the grinding means is connected to the brush support and whereby both the grinding means and the brush means are substantially rectangular.

9. Method according to claim 8, **characterized in that** a plurality of planar members (2) to be grinded are successively supplied to the grinding and cleaning means (15, 10).

## Patentansprüche

1. Schleifgerät zum Schleifen eines ebenen Bauteils (2), mit einer Schleifvorrichtung (15) und einer Antriebvorrichtung (12) zum Bewegen der Schleifvorrichtung (15), **gekennzeichnet durch**:
a) eine Bürstenhalterung (11), die auf ihrer Unterseite einen im wesentlichen rechteckigen Bürstenkörper (10) aufweist;
b) eine im wesentlichen rechteckige Schleifvorrichtung (15), die mit der Bürstenhalterung (11) verbunden ist, wobei das untere Ende der Schleifvorrichtung (15) sich im wesentlichen auf derselben Höhe befindet wie das untere Ende des Bürstenkörpers (10);
c) eine Welle (12), die mit der Antriebsvorrichtung (12) und sowohl mit der Bürstenhalterung (11) als auch mit der Schleifvorrichtung (15) verbunden ist und in Bezug auf die Mittelachse der Bürstenhalterung (11) und der Schleifvorrichtung (15) exzentrisch angeordnet ist.

2. Schleifgerät nach Anspruch 1, **dadurch gekennzeichnet**, daß die Bürstenhalterung (11) und die Schleifvorrichtung (15) Platten mit rechteckigem Querschnitt sind, deren längere Seiten parallel zueinander angeordnet sind.

3. Schleifgerät nach Anspruch 1, **gekennzeichnet durch** eine Fördereinrichtung (3) für die Zuführung eines ebenen Bauteils (2) zu dem Bürstenkörper (10) und zu der Schleifvorrichtung (15).

4. Schleifgerät nach Anspruch 3, **gekennzeichnet durch** ein Gehäuse (1) mit einem ersten Schlitz (13) zum Einführen des ebenen Bauteils (2) in das Gehäuse (1) und einem zweiten Schlitz (14) zum Entnehmen des ebenen Bauteils (2) aus dem Gehäuse, wobei die Fördereinrichtung (3) zwischen dem ersten und dem zweiten Schlitz (13, 14) vorgesehen ist.

5. Schleifgerät nach Anspruch 1, **gekennzeichnet durch** eine Hochdruckwasserspritzeinrichtung zum Einspritzen von Wasser in den Bürstenkörper (10), um Kupferstaub und Schleifabfälle von der Oberfläche (2a) des geschliffenen ebenen Teils (2) zu waschen.

6. Schleifgerät nach Anspruch 1, **dadurch gekennzeichnet,** daß das ebene Bauteil eine gedruckte Leiterplatte (2) ist und daß die gedruckte Leiterplatte auf der Fördereinrichtung (3) durch die Schleifvorrichtung (15) geschliffen wird.

7. Schleifgerät nach Anspruch 1, **dadurch gekennzeichnet**, daß die Bürstenhalterung (11) und ein Schleifstein (15) so gehalten werden, daß die Druckkräfte zum Schleifen des ebenen Bauteils (2) einstellbar sind.

8. Verfahren zum Schleifen eines ebenen Bauteils (2) mit einer Schleifvorrichtung (15) und mit einer Antriebsvorrichtung (12), die die Schleifvorrichtung (15) bewegt, **gekennzeichnet durch** folgende Schritte:
a) Bewegen eines ebenen Bauteils (2) von einer ersten Position (13) zu einer zweiten Position (14);
b) Schleifen und Säubern des ebenen Bauteils (2) zwischen der ersten Position (13) und der zweiten Position (14), indem die Schleifvorrichtung (15) zusammen mit einer Bürstenvorrichtung (10) von einer Welle (12), die mit Bezug auf den Mittelpunkt der Schleifvorrichtung (15) exzentrisch angeordnet ist, exzentrisch über die Oberfläche des ebenen Bauteils (2) bewegt wird, wobei die Schleifvorrichtung (15) zwischen der zweiten Position (14) und der Bürstenvorrichtung (10) angeordnet ist, wobei die Schleifvorrichtung mit der Bürstenhalterung verbunden ist und wobei sowohl die Schleifvorrichtung als auch die Bürstenvorrichtung im wesentlichen rechteckig sind.

9. Verfahren nach Anspruch 8, **dadurch gekennzeichnet**, daß mehrere zu schleifende ebene Bauteile (2) nacheinander den Schleif- und Reinigungsvorrichtungen (15, 10) zugeführt werden.

## Revendications

1. Appareil de ponçage pour poncer un élément plan (2) comprenant un dispositif de ponçage (15) et un dispositif de commande (12) pour déplacer ledit dispositif de ponçage (15), caractérisé par:
a) un support de brosse (11) portant à son extrémité inférieure une brosse essentiellement rectangulaire (10);
b) un dispositif de ponçage essentiellement rectangulaire (15) à fixer au support de la brosse (11), l'extrémité inférieure dudit dispositif de ponçage (15) étant disposée essentiellement au même niveau que l'extrémité inférieure de ladite brosse (10);
c) un axe (12) à raccorder audit dispositif de commande (12) et tant audit support de la brosse (11) qu'audit dispositif de ponçage (15) et à disposer excentriquement par rapport à l'axe central dudit support de la brosse (11) et dudit dispositif de ponçage (15).

2. Appareil de ponçage selon la revendication 1 caractérisé en ce que ledit support de la brosse (11) et ledit dispositif de ponçage (15) sont des plaques présentant des sections transversales rectangulaires, les côtés les plus longs desdites plaques étant parallèles l'un à l'autre.

3. Appareil de ponçage selon la revendication 1 caractérisé par un transporteur (3) pour amener un élément plan (2) à ladite brosse (10) et audit dispositif de ponçage (15).

4. Appareil de ponçage selon la revendication 3, caractérisé par un boitier (1) présentant une première fente (13) pour introduire ledit élément plan (2) dans ledit boitier (1) et une deuxième fente (14) pour faire sortir ledit élément plan (2) dudit boitier, le transporteur (3) étant disposé entre lesdites première et deuxième fentes (13, 14).

5. Appareil de ponçage selon la revendication 1, caractérisé par un pulvérisateur d'eau à haute pression pour injecter de l'eau dans ladite brosse (10) afin de rincer la poudre de cuivre et les poussières de la surface (2a) de l'élément plan poncé (2).

6. Appareil de ponçage selon la revendication 1 caractérisé en ce que l'élément plan est une carte de circuits imprimés (2) et en ce que ladite carte de circuits imprimés est poncée sur le transporteur (3) par le dispositif de ponçage (15).

7. Appareil de ponçage selon la revendication 1 caractérisé en ce que le support de la brosse (11) et une pierre ponce (15) sont soutenus de sorte que les forces de poussée pour poncer l'élément plan (2) soient réglables.

8. Méthode de ponçage d'un élément plan (2) avec un dispositif de ponçage (15) et un dispositif d'entraînement (12) pour déplacer ledit dispositif de ponçage (15) caractérisée par les étapes suivantes:
a) le déplacement d'un élément plan (2) à poncer d'une première position (13) vers une deuxième position (14);
b) le ponçage et le nettoyage dudit élément plan (2) entre ladite première position (13) et ladite deuxième position (14) en déplaçant excentriquement ledit dispositif de ponçage (15) avec une brosse (10) par un axe (12) à disposer excentriquement par rapport au centre dudit dispositif de ponçage (15) sur la surface dudit élément plan (2), ledit dispositif de ponçage (15) étant disposé entre ladite deuxième position (14) et ladite brosse (10), le dispositif de ponçage étant raccordé au support de la brosse et le dispositif de ponçage et la brosse étant essentiellement rectangulaires.

9. Méthode selon la revendication 8 caractérisée en ce que plusieurs éléments plans (2) à poncer sont successivement amenés au dispositif de ponçage et de nettoyage (15, 10).
